(19) Europäisches Patentamt
European Patent Office
Office européen des brevets

(11) EP 0 737 897 A1

(12) **EUROPÄISCHE PATENTANMELDUNG**

(43) Veröffentlichungstag:
**16.10.1996 Patentblatt 1996/42**

(51) Int. Cl.[6]: **G03F 7/039**, G03F 7/40

(21) Anmeldenummer: **95810170.1**

(22) Anmeldetag: **15.03.1995**

(84) Benannte Vertragsstaaten:
**AT BE CH DE DK ES FR GB GR IE IT LI LU MC NL PT SE**

(71) Anmelder:
- **OCG Microelectronic Materials Inc.**
  **West Paterson New Jersey 07424 (US)**
- **OCG Microelectronic Materials AG**
  **CH-4002 Basel (CH)**

(72) Erfinder:
- **Schädeli, Ulrich**
  **1737 Plasselb (CH)**
- **Hofmann, Manfred**
  **1723 Marly (CH)**
- **Münzel, Norbert**
  **79423 Heitersheim (DE)**
- **Grubenmann, Arnold**
  **1723 Marly (CH)**

(74) Vertreter: **Klunker . Schmitt-Nilson . Hirsch**
**Winzererstrasse 106**
**80797 München (DE)**

(54) **Nasschemisch entwickelbares, ätzstabiler Photoresist für UV-Strahlung mit einer Wellenlänge unter 200 nm**

(57) Es werden Photoresistzusanmmensetzungen beschrieben, welche in lösungsmittelfreiem Zustand für Strahlung einer Wellenlänge von ca. 193 nm ausreichend transparent sind und welche nichtaromatische chemische Gruppen enthalten, die sich unter Verfahrensbedingungen, bei denen eine bildhafte Struktur aus dem Resistmaterial nicht zerstört wird, in Gruppen mit aromatischen Strukturelementen überführen lassen (latent aromatische Gruppen). Eine bevorzugte Komponente mit latent aromatischen Gruppen ist Bicyclo[3.2.2]nona-6,8-dien-3-on. Resistbeschichtungen, die mit diesen Zusammensetzungen hergestellt sind, zeigen ein Stabilität bei der Plasmaätzung, die vergleichbar ist mit der Stabilität von herkömmlichen Resists basierend auf phenolischen Harzen.

EP 0 737 897 A1

## Beschreibung

Die Erfindung betrifft eine Photoresistzusammensetzung für UV-Strahlung mit einer Wellenlänge unter 200 nm, und ein Verfahren zur lithographischen Behandlung eines Substrats.

Bei der mikrolithographischen Erzeugung von Strukturen auf einem Substrat wird bekanntlich das Substrat, z. B. Silizium, Siliziumoxid oder Siliziumnitrid, mit einer Photoresistzusammensetzung beschichtet und diese Beschichtung selektiv mit Strahlung einer geeigneten Wellenlänge bestrahlt, so dass das bestrahlte Resistmaterial eine vom unbelichteten Material verschiedene Löslichkeit in einer Entwicklerlösung aufweist. Die bestrahlte Beschichtung wird schliesslich mit dem Entwickler behandelt, wobei sie aufgrund der unterschiedlichen Löslichkeiten bildhaft strukturiert wird. Das bildhaft beschichtete Substrat kann dann an den von Resist freien Stellen einer weiteren Behandlung unterzogen werden. Häufig handelt es sich hierbei um eine Plasmaätzung, wobei z. B. ein Siliziumoxid- oder Siliziumnitridsubstrat mit einem Halogen/Sauerstoffplasmagemisch, z. B. einem $Cl_2/O_2$- oder einem $CF_4/O_2$-Plasma geätzt wird, gegen das die Resistbeschichtung natürlich ausreichend stabil sein muss. Die mikrolithographisch maximal erreichbare Auflösung wird wesentlich von der Wellenlänge der zur selektiven Bestrahlung verwendeten Strahlung bestimmt. Seit längerem bereits ist man für viele Anwendungen zum Einsatz von Deep UV-Strahlung übergegangen, insbesondere von Strahlung mit einer Wellenlänge von 200 bis 250 nm. Verbreitet wird z. B. Strahlung von 248 nm eingesetzt, die mit Kryptonfluorid-Excimerlasern erzeugt werden kann.

Das mit der herkömmlichen Deep UV-Mikrolithographie erreichbare Auflösungsvermögen hat jedoch seine Grenze erreicht. So erlaubt sie es gerade noch, Strukturen mit Abmessungen bis hinab zu ca. 0,20 µm aufzulösen, während für die in neuester Zeit angestrebte Herstellung von 4 Gigabytespeicherelementen beispielsweise oder von ähnlich hochintegrierten elektronischen Bauteilen die Ausbildung wesentlich feinerer Strukturelemente erforderlich ist, die Kleinste Abmessungen von bis zu ca. 0,12 µm aufweisen. Um derart feine Strukturelemente optisch noch ausreichend auflösen zu können, muss noch kurzwelligere als Deep UV-Strahlung eingesetzt werden. Insbesondere kommt hierfür die Strahlung von Argonfluorid-Excimerlasem in Frage, die eine Wellenlänge von 193 nm hat.

Das heute gebräuchliche Deep UV-Photoresistmaterial ist aber für solche Strahlungen nicht geeignet. Das Material basiert nämlich üblicherweise auf phenolischen Harzen als Bindemittel, beispielsweise auf Novolakharzen oder auf Polyhydroxystyrolderivaten, die aufgrund ihrer aromatischen Strukturelemente eine zu starke Absorption bei Wellenlängen unter 200 nm zeigen. Dies führt aber dazu, dass bei Verwendung solcher Strahlung die Seitenwände der fertig entwickleten Resiststrukturen nicht den angestrebten rechten Winkel sondern einen mehr oder weniger schiefen Winkel mit der Substratbeziehungsweise der Resistoberfläche bilden, was einen Gewinn an optischer Auflösung infolge des Einsatzes der kürzerwelligen Strahlung wieder zunichte macht.

Es ist daher vorgeschlagen worden, Photoresists auf Basis von Methacrylatharzen für die Erzeugung von Strukturen mit Hilfe von 193 nm-Strahlung einzusetzen. (Roderick R. Kunz et al.: "RESIST PROCESS FOR ArF EXCIMER LASER LITHOGRAPHY"; Journal of Photopolymer Science and Technology, Vol. 6 (1993), S. 473 - 490). Die genannten Photoresists erweisen sich zwar ausreichend transparent für diese Strahlung, weisen jedoch nicht die von Resists auf Basis phenolischer Harze gewohnte Stabilität bei der Plasmaätzung auf. Die Ätzstabilität geht nämlich wesentlich auf die aromatischen Gruppen in diesen Resists zurück. (James R. Sheats: "PHOTORESISTS FOR DEEP UV LITHOGRAPHY"; Solid State Technology 1989, S. 79 - 86).

Es gab auch schon einige Lösungsansätze für dieses Problem. Beispielsweise ist versucht worden, die Ätzstabilität von Photoresists auf (Meth)acrylatbasis durch Einführung cycloaliphatischer Gruppen in die (Meth)acrylatpolymere zu verbessern (Robert D. Allen et al.: "SINGLE LAYER RESISTS WITH ENHANCED ETCH RESISTANCE FOR 193 nm LITHOGRAPHY", Journal of Photopolymer Science and Technology, Vol. 7 (1994), S. 507 - 516). Dies führt zwar zu einer Verbesserung der Ätzstabilitäten, allerdings nicht in dem angestrebten Masse. So liegt beispielsweise die Ätzrate von Poly(isobornyl)acrylat im Sauerstoff- oder Chlorplasma noch immer ca. 50 bis 70% höher als die von Novolakharzen (Roderick R. Kunz et al.: "RESIST PROCESS FOR ArF EXCIMER LASER LITHOGRAPHY"; Journal of Photopolymer Science and Technology, Vol. 6 (1993), S. 473-490).

Ein anderer Vorschlag zielt darauf ab, eine ausreichende Ätzstabilität erst nach Bestrahlung in der Resistbeschichtung zu erzeugen. Hierzu wurde vorgeschlagen, das Substrat mit der fertig entwickelten, bildhaft strukturierten Photoresistbeschichtung in geeigneter Weise mit bestimmten Alkylverbindungen des Magnesiums oder Aluminiums zu behandeln, um auf diese Weise die genannten Metalle als Ätzbarriere in das Resistmaterial einzubringen (US-A-4,690,838). Die Verwendung metallhaltiger Reagenzien ist jedoch bei Mikrolithographieverfahren wegen der damit verbundenen Gefahr einer Kontamination des Substrats mit Metallionen im allgemeinen unerwünscht.

Auch nichtaromatische chemische Verbindungen, die sich in relativ einfacher Weise in Verbindungen mit aromatischen Gruppen umwandeln lassen (nachfolgend auch als "latent aromatische Verbindungen" bezeichnet), sind schon bekannt. So reagieren Bicyclo[3.2.2]nona-6,8-dien-on unter Säurekatalyse zu Phenylaceton (A. E. Hill et al.: "ONE STAGE SYNTHESIS OF BICYCLO[3.2.2]NONA-6,8-DIEN-3-ONES", Journal of the American Chemical Society, Vol. 96 (1974), S. 4597 - 4603) und bestimmte Poly(cyclohexadiencarbonate) und -acetate ebenfalls unter Säurekatalyse oder auch nur bei Erwärmung zu Polyphenylenen (US-A-5,248,734).

Ein chemisch verstärkter Positivphotoresist für den Einsatz im Deep UV Bereich, der aus Poly(cyclohexa-1,3-dien-5,6-diacetat) und Triphenylsulfoniumtrifluorosulfonat als strahlungsempfindlichem Säurespender besteht, ist ebenfalls schon beschrieben worden (JP-A-05/061198). Nach Belichtung mit 248 nm-Strahlung und Entfernung der bestrahlten Partien der Resistschicht mit einer alkalischen Entwicklerlösung wird das Substrat mit der bildhaft strukturierten Resistbeschichtung gemäss der Lehre dieses Dokuments auf 200 °C erhitzt, so dass das Poly(cyclohexa- 1,3-diene-5,6-diacetat) in den verbliebenen Partien der Beschichtung zum Polyphenylen abreagiert. Der genannte Photoresist zeigt eine gute Transparenz für die Strahlung von 248 nm Wellenlänge und eine gute Stabilität bei einer späteren Plasmaätzung.

Es wurde nun gefunden, dass sich mit Hilfe von latent aromatischen Verbindungen auch Photoresistzusammensetzungen formulieren lassen, die eine Resistbeschichtung ergeben, die für Strahlung mit einer Wellenlänge von ca. 193 nm noch ausreichend transparent ist und die dennoch nach Umwandlung der latent aromatischen Gruppierungen zu aromatischen Gruppen ausreichend stabil bei der Plasmaätzung ist. Dies war nicht zu erwarten, besonders weil die bekannten latent aromatischen Gruppen isolierte Kohlenstoffdoppelbindungen enthalten, die im UV-Spektrum bekanntlich bei ca. 190 - 200 nm eine starke Absorptionsbande zeigen. Auf diese Weise ist es erstmals möglich, einen nasschemisch entwickelbaren Photoresist für Strahlung von ca. 193 nm Wellenlänge zu formulieren, der eine vergleichbare Ätzrate wie herkömmliche Resists auf Basis phenolischer Harze zeigt, und dies, ohne dass man die Resistbeschichtung zur Steigerung der Ätzstabilität mit Metallverbindungen behandeln muss.

Gegenstand der vorliegenden Erfindung ist somit eine Photoresistzusammensetzung, welche in lösungsmittelfreiem Zustand für Strahlung einer Wellenlänge von ca. 193 nm ausreichend transparent ist und welche nichtaromatische chemische Gruppen enthält, die sich unter Verfahrensbedingungen, bei denen eine bildhafte Struktur aus dem Resistmaterial nicht zerstört wird, in Gruppen mit aromatischen Strukturelementen überführen lassen. Diese Gruppen werden nachfolgend auch als latent aromatische Gruppen bezeichnet.

Als ausreichend transparent für eine bestimmte Strahlung wird ein moderner Photoresist für den Submikronbereich üblicherweise dann angesehen, wenn seine Extinktion bei der Wellenlänge der Strahlung, bezogen auf eine Resistdicke von einem Mikrometer, einen Wert von ca. 0,8, bevorzugt von 0,5 nicht übersteigt. Als Extinktion wird hierbei die Grösse $E = \log (I_0/I)$ bezeichnet, worin $I_0$ die Intensität der Strahlung vor der Photoresistschicht und I die Intensität der Strahlung nach der Photoresistschicht ist. Eine Extinktion von 0,8/μm (0,5/μm) bedeutet, dass ein Film des Photoresists von 1μm Dicke ca. ein Fünftel (Drittel) der Strahlung passieren lässt, d.h. einen Wert für die Transmission $T = 10^{-E}$ von 0,16(0,3) zeigt. Weist ein Photoresist eine grössere Extinktion als 0,7/μm bei der zur Belichtung verwendeten Strahlung auf, so zeigen die Winkel, die die Seitenwände des Resistprofils mit dem Substrat bilden, im allgemeinen bereits eine sehr starke Abweichung von den erwünschten 90° und liegen oftmals schon im Bereich von 80°. Den genauen Wert der Extinktion eines Photoresists kann man einfach ermitteln, indem man z. B. eine Resistschicht bekannter Dicke auf einen geeigneten Quarzträger aufbringt, den Träger in ein UV-Spektrometer einbringt und ein UV-Spektrum aufnimmt.

Prinzipiell ist es für die Formulierung der erfindungsgemässen Photoresists gleichgültig, welcher Bestandteil des Resists die latent aromatischen Gruppen aufweist, solange die Gruppen in so ausreichender Menge in dem Resist vorhanden sind, dass die gebildeten aromatischen Gruppen die erwünscht niedrige Ätzrate ergeben. Beispielsweise kann das Bindemittel oder ein Teil des Bindemittels des Resists latent aromatische Gruppen als Seitengruppen oder in der Hauptkette oder auch beides enthalten. Polymere mit latent aromatischen Gruppen in der Hauptkette können z. B. aus den im US-Patent US-A-5,248,734 beschrieben Polymeren und Copolymeren auf Basis von 1,2-disubstituierten Polycyclohexa-3,5-dien-Monomeren ausgewählt werden. Für die vorliegende Erfindung sind diejenigen Polymere und Copolymere aus der genannten Referenz geeignet, deren Hauptkette aus gleichen oder verschiedenen Baugruppen der nachstehenden Formel (I)

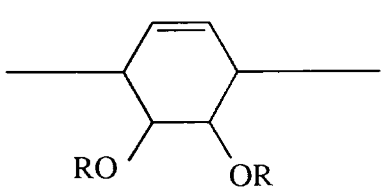

(I)

worin die Reste R gleiche oder verschiedene Reste ausgewählt aus Wasserstoff, $C_1$-$C_5$-Alkyl, $C_1$-$C_{10}$-Alkanoyl und -$COOC_1$-$C_{10}$-Alkyl bedeuten, sowie gegebenenfalls zusätzlich aus zweiwertigen Resten anderer copolymerisierter Monomere ohne aromatische oder konjugiert ungesättigte Gruppen besteht. Bei den genannten Copolymeren kann das Molverhältnis von Einheiten der Formel (I) und Comonomereneinheiten im allgemeinen zwischen 1:1 und 1:100 liegen. Als Comonomere kommen z. B. einfach ungesättigte Olefine, insbesondere Vinylverbindungen, Acrylate, Methacrylate, Acrylamide, Methacrylamide oder Maleinimide in Frage, die keine aromatischen oder konjugiert ungesättigten Gruppen aufweisen.

Polymere mit latent aromatischen Seitengruppen können ebenfalls in einfacher Weise, beispielsweise durch Polymerisation von latent aromatischen Monomeren mit Vinylgruppen hergestellt werden. So kann man z. B. Phenylvinylether mit 2-Methoxyallylbromid gemäss der weiter unten angegebenen Vorschrift von A. E. Hill et al. umsetzen und danach polymerisieren oder (Meth)acrlysäurepolymere oder - copolymere mit cis-3-Methyl-3,5-cyclohexadien-1,2-diol umsetzen. Die polymeren latent aromatischen Verbindungen haben den Vorteil, dass ein u. U. mit einer Verminderung der Ätzstabilität des Resists verbundenes Ausdiffundieren des latenten Aromaten praktisch ausgeschlossen ist.

Eine andere Ausführungsform der erfindungsgemässen Resists enthält die latent aromatische Verbindung als eine separate Komponente speziell für diesen Zweck, da man dann in der Lage ist, den Anteil des latenten Aromaten in einfacher Weise und in relativ starkem Ausmass unabhängig von den Komponenten des Resists, die andere Funktionen haben, zu variieren, ohne dass ungewollt andere wichtige Eigenschaften des Resists in unerwünschter Weise zu beeinflusst werden. Besonders bevorzugt sind daher erfindungsgemässe Resists, die Bicyclo[3.2.2]nona-6,8-dien-3-on als latent aromatische Verbindung enthalten. Die Herstellung von Bicyclo[3.2.2]nona-6,8-dien-3-on ist z. B. durch Umsetzung von 2-Methoxyallylbromid mit Benzol gemäss der Vorschrift in dem Aufsatz von A. E. Hill et al.: "ONE STAGE SYNTHESIS OF BICYCLO[3.2.2]NONA-6,8-DIEN-3-ONES", Journal of the American Chemical Society, Vol. 96 (1974), S. 4597 - 4603 möglich. Ein besonderer Vorteil dieses Verbindungstyps gegenüber Poly(cyclohexadien)derivaten, wie sie in dem eingangs zitierten US-Patent US-A-5,248,737 erwähnt sind, besteht darin, dass die Aromatisierung auf einer gewichtsneutralen chemischen Umlagerungsreaktion beruht, im Gegensatz zu einer Eliminierungsreaktion bei den Verbindungen gemäss US-A-5,248,737, mit der im allgemeinen ein Volumenverlust einher geht, welcher zu unerwünschten Veränderungen der Resistprofile führen kann.

Für die säureinduzierte Aromatisierung kommen eine Vielzahl von Verbindungstypen in Betracht, beispielsweise auch die von Mc. Keown et al. beschriebenen Umsetzungsprodukte von Fumaronitril und cyclischen Dienen oder auch cis-3-Methyl-3,5-cyclohexadien-1,2-diol, dessen maximale Extinktion in Gegenwart von Säure von 0,6/μm auf 1,6/μm steigt, vermutlich weil unter Wasserelimination Phenol gebildet wird.

Bei der Verschiedenheit latentaromatischer Komponenten ist es selbstverständlich, dass ihr Anteil an den erfindungsgemässen Resists in weiten Grenzen variieren kann. Wesentlich im Hinblick auf die Menge ist lediglich, dass der Resist bei 193 nm noch ausreichend transparent ist und gleichzeitig eine ausreichende Ätzstabilität erreicht wird. Die Unter- und Obergrenze kann der Fachmann für eine bestimmte latent aromatische Komponente ohne Aufwand durch wenige Routineversuche festlegen. Bevorzugt sind erfindungsgemässe Photoresists, deren Ätzrate für ein bestimmtes Plasma möglichst gering ist oder, besonders bevorzugt, der eines herkömmlichen Photoresists auf Novolakbasis entspricht. Bevorzugt enthalten daher die erfindungsgemässen Photoresists die latent aromatischen Gruppen z. B. in einer Menge, dass die Ätzrate des Resists im Sauerstoffplasma 150 bis 100 (± 10) nm/min beträgt. Ein üblicher Photoresist auf Novolakbasis, z. B. Microposit® 1350 der Firma SHIPLEY, zeigt im Sauerstoffplasma eine Ätzrate von ca. 105 (± 10) nm/min, bestimmt mit einem Plasmaätzer des Typs Alcatel CF 2P® (Flow: 10 s • $cm^3$; RE Power: 30 W; $O_2$ Pressure: 2,0 Pa und Bias: 420 V).

Abhängig von ihren Bestandteilen sind die erfindungsgemässen Photoresists entweder Positivresists oder Negativresists. Bevorzugt handelt es sich in beiden Fällen weiterhin um chemisch verstärkte Photoresists, d. h. um Photoresists, die Gruppen enthalten, die unter dem Einfluss von Strahlung eine starke Säure bilden (nachfolgend auch als "strahlungsempfindlicher Säurespender" bezeichnet), sowie Gruppen, die unter katalytischer Wirkung dieser Säure die Löslichkeit des Resists in einer gewünschten Entwicklerlösung verändern. Die genannten Gruppen können hierbei ebenso Teil einer wie auch verschiedener Komponenten des Resists sein.

Negativresists, deren Material bekanntlich in unbestrahltem Zustand in einer Entwicklerlösung löslich, in bestrahltem Zustand jedoch unlöslich ist, enthalten im allgemeinen entweder Gruppen, die unter dem Einfluss der Strahlung direkt vernetzen, oder, im Falle chemisch verstärkter Photoresists, sowohl Gruppen, die unter dem Einfluss von Strahlung eine starke Säure bilden, als auch Gruppen, die katalysiert von dieser Säure vernetzen, wobei in beiden Fällen die Vernetzung den Resist in üblichen Lösungsmitteln unlöslich macht. Die Art der vernetzbaren Verbindungen ist unkritisch, sieht man von ihrem Absorptionsverhalten für Strahlung von ca. 193 nm ab. Geeignet sind beispielsweise entsprechende polyfunktionelle (Meth)acrylate als vernetzbare Komponente, die dem Fachmann vertraut sind. Die Art des strahlungsempfindlichen Säurespenders ist ebenfalls unkritisch, und es können alle dem Fachmann bekannten entsprechenden Verbindungen eingesetzt werden, wie z. B. die weiter unten in, Zusammenhang mit den Positivresists hierfür beschriebenen Substanzen. Der strahlungsempfindliche Säurespender wird im allgemeinen nur in relativ geringen Mengen, eingesetzt, beispielsweise in einer Menge von 0,01 bis 10, insbesondere von 0,1 bis 5 Gewichtsprozent.

Besonders bevorzugt sind jedoch erfindungsgemässe Positivphotoresists, d. h. Resists, deren Material in unbestrahltem Zustand in einer Entwicklerlösung relativ unlöslich, dagegen in bestrahltem Zustand löslich ist, so dass die bestrahlten Partien mit Hilfe des Entwicklers gelöst und vom Substrat entfernt werden können. Ganz besonders bevorzugt sind Positivresists, deren Material in unbestrahltem Zustand in wässerig alkalischen Entwicklern unlöslich ist, während es in bestrahltem Zustand darin löslich ist. Bevorzugt sind weiterhin chemisch verstärkte Positivphotoresists, also Resists mit Gruppen, die unter dem Einfluss von Strahlung eine Säure bilden, sowie Gruppen, die unter katalytischer Wirkung dieser Säure die Löslichkeit des Resists in wässerig alkalischen Entwicklern verbessern.

Im allgemeinen handelt es sich bei den säurekatalytisch die Löslichkeit in wässerig alkalischen Medien erhöhenden Gruppen um Gruppen, die säurekatalytisch spaltbar sind, wobei einer oder mehrere Reste mit funktionellen Gruppen entstehen, die die Löslichkeit des Resists in wässerigem Alkali so stark erhöhen, dass die belichteten Teile des

Resists von einem Substrat entfernt werden können. Säurekatalytisch spaltbare Gruppen sind in vielfacher Form bekannt und können im allgemeinen alle zur Anwendung kommen, solange sie keine bei unterhalb von 200 nm stark absorbierenden Atomgruppierungen enthalten, weil der Resist sonst eine unerwünschte Absorptionscharakteristik aufweist. Beispielsweise kann es sich um Gruppen der Formel $-OR_1$ handeln, worin $R_1$ für $C_4$-$C_{10}$-tert.-Alkyl, unsubstituiertes oder durch eine oder mehrere $C_1$-$C_6$-Alkylgruppen, $C_1$-$C_6$-Alkoxygruppen oder Halogenatome substituiertes Allyl, Cyclohex-2-enyl, Trialkylsilyl, oder für eine Gruppe der folgenden Formeln steht:

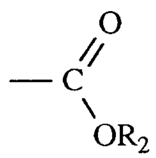 , 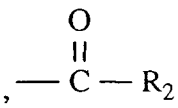 , 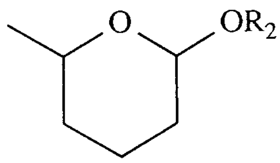 , 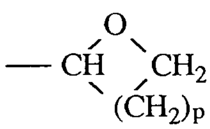 ,

worin $R_2$ für $C_1$-$C_6$-Alkyl und p für eine der Zahlen 4 oder bevorzugt 3 oder 2 stehen. Die säurespaltbaren Gruppen können prinzipiell an alle Bestandteile der erfindungsgemässen Resists gebunden sein. Besonders bevorzugt weist jedoch das Bindemittel säurekatalytisch spaltbare Gruppen auf. Es ist aber auch möglich, den erfindungsgemässen Resists eine zusätzliche Komponente mit säurekatalytisch spaltbaren Gruppen als Lösungsinhibitor in Verbindung mit einem alkalilöslichen Bindemittel zuzugeben, wobei die Lösungsinhibitoren verhindern, dass sich das nichtbestrahlte Resistmaterial in wässerig alkalischen Entwicklermedien löst.

Eine bevorzugte Ausführungsform der erfindungsgemässen Resists stellen chemisch verstärkte wässerig alkalisch entwickelbare Positivphotoresists dar, die die folgenden Komponenten enthalten:

A) eine Verbindung, die unter dem Einfluss von Strahlung eine starke Säure bildet,
B) ein filmbildendes für Strahlung von ca. 193 nm Wellenlänge ausreichend transparentes Bindemittel, das säurespaltbare Gruppen aufweist, und
C) eine Verbindung mit latent aromatischen Gruppen

oder anstatt der Komponenten B) und C)

D) ein filmbildendes für Strahlung von ca. 193 nm Wellenlänge ausreichend transparentes Bindemittel, das säurekatalytisch spaltbare Gruppen und latent aromatischen Gruppen aufweist.

Die genannten Photoresists enthalten die Komponente A im allgemeinen in einer Menge von 0,01-10 Gewichtsprozent, bezogen auf das Gesamtgewicht der Komponenten A, B und C. Bevorzugt sind aber im allgemeinen relativ geringe Mengen an strahlungsempfindlichem Säurespender, z. B. 0,01 bis 6, insbesondere 0,1 bis 3 Gewichtsprozent. Die Komponente B macht im allgemeinen 50 bis 85 Gewichtsprozent und die latent aromatische Verbindung ca. 15 bis 40 Gewichtsprozent der Komponenten A, B und C aus.

Als Komponente A können alle bekannten Verbindungen eingesetzt werden, die unter der Einwirkung von aktinischer Strahlung Säure bilden. Eine grosse Zahl solcher Verbindungen ist z. B. in der EP-A-0 601 974 (= US-A-5,369,200) genannt, deren Beschreibung auch ein Bestandteil dieser Beschreibung sein soll. Bevorzugte strahlungsempfindliche Säurespender sind Oniumsalze, wie Diazonium-, Sulfonium-, Sulfoxonium- und Iodoniumsalze, sowie Disulfone und Verbindungen der Formel

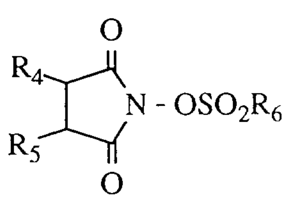 ,

worin $R_4$ und $R_5$ unabhängig voneinander für $C_1$-$C_4$-Alkyl, $C_1$-$C_4$-Alkoxy oder Phenyl stehen oder zusammen einen Rest der nachstehenden drei Formeln

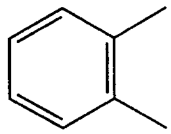, 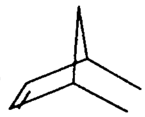, 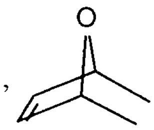

bedeuten und $R_6$ unsubstituiertes oder durch Halogen, Nitro oder $C_1$-$C_4$-Alkoxy substituiertes $C_1$-$C_{12}$-Alkyl oder unsubstituiertes oder durch Halogen, Nitro, $C_1$-$C_4$-Alkyl oder $C_1$-$C_4$-Alkoxy substituiertes Phenyl.

Besonders bevorzugt sind Sulfoniumsalze der Formel (II)

$$(Ar_1)_q(Z_1)_r(Z_2)_sS^{\oplus}X_1^{\ominus} \qquad \text{(II)},$$

worin

- $Ar_1$ unsubstituiertes oder durch Halogen, $C_1$-$C_4$-Alkyl, $C_1$-$C_4$-Alkoxy, - OH und/oder nitro-substituiertes Phenyl, Naphthyl oder Phenyl-$COCH_2$- ist,
- $Z_1$ $C_1$-$C_6$-Alkyl oder $C_3$-$C_7$-Cycloalkyl und
- $Z_2$ Tetrahydrothienyl, Tetrahydrofuryl oder Hexahydropyryl sind,
- q für 0, 1,2 oder 3,
- r für 0, 1 oder 2 und
- s für 0 oder 1 stehen, wobei die Summe q+r+s 3 beträgt, und
- $X_1^{\ominus}$ ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

Phenyl-, Naphthyl- und Phenacylgruppen $Ar_1$ sind bevorzugt einfach substituiert, insbesondere durch Cl, Br, Methyl, Methoxy, -OH oder Nitro. Besonders bevorzugt sind diese Reste unsubstituiert. $Z_1$ ist vorzugsweise $C_1$-$C_4$-Alkyl, insbesondere Methyl oder Ethyl. Bevorzugt sind q 2 oder 3, r 1 oder Null und s Null, insbesondere ist q die Zahl 3 und r und s sind Null. Ganz besonders bevorzugt ist $Ar_1$ unsubstituiertes Phenyl und q ist 3.

Stellt $X_1^{\ominus}$ das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonder Fluor, Alkyl, wie Methyl, Ethyl oder n-Propyl, oder Alkoxy, wie Methoxy, Ethoxy oder n-Propoxy.

Vorzugsweise handelt es sich bei $X_1^{\ominus}$ um das einwertige Anion einer organischen Sulfonsäure, insbesondere einer Teilfluor- oder Perfluorsulfonsäure. Diese Anionen zeichnen sich durch eine besonders geringe Nucleophilie aus.

Spezielle Beispiele für geeignete Sulfoniumsalze der Formel (II) sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydiothiopheniumchlorid, 4-Nitrophenacyltetrahydrothiopheniumchlorid und 4-Hydroxy-2-methylphenylhexahydrothiopyryliumchlorid. Besonders bevorzugt ist Triphenylsulfoniumtrifluormethansulfonat (Triphenylsulfoniumtriflat).

Besonders bevorzugt verwendet man als Komponente A) solche Verbindungen der obigen Formel (II), worin

- $Ar_1$ Phenyl bedeutet,
- q die Zahl 3 ist,
- r und
- s Null sind, und
- $X_1^{\ominus}$ $SbF_6^{\ominus}$, $AsF_6^{\ominus}$, $PF_6^{\ominus}$, $CF_3SO_3^{\ominus}$, $C_2F_5SO_3^{\ominus}$, n-$C_3F_7SO_3^{\ominus}$, n-$C_4F_9SO_3^{\ominus}$, n-$C_6F_{13}SO_3^{\ominus}$, n-$C_8F_{17}SO_3^{\ominus}$ oder $C_6F_5SO_3^{\ominus}$ darstellt.

Als Bindemittelkomponente B kommen insbesondere in wässerig alkalischen Entwicklern lösliche Polymere und Copolymere von einfach ungesättigten Olefinen, insbesondere Vinylverbindungen, von einfach ungesättigten Carbonsäuren, insbesondere Acrylsäure und Methacrylsäure, von Acrylaten, Methacrylaten, Acrylamiden, Methacrylamiden oder von Maleinimiden in Frage, die durch Einführung einer ausreichenden Menge geeigneter, säurekatalytisch spaltbarer Gruppen in wässerig alkalischen Medien unlöslich gemacht worden sind. Bevorzugt handelt es sich hierbei um Copolymere eines oder mehrerer der genannten Monomeretypen, insbesondere von Methacrylaten, mit Acryl- und insbesondere Methacrylsäure, wobei ein ausreichender Teil der freien Carbonxylgruppen der Acrylsäure- und Methacrylsäureeinheiten zu Gruppen der Formel -$COOR_3$ umgesetzt ist, wobei $R_3$ für $C_4$-$C_{10}$-tert.-Alkyl, unsubstituiertes oder durch eine oder mehrere $C_1$-$C_6$-Alkylgruppen, $C_1$-$C_6$-Alkoxygruppen oder Halogenatome substituiertes Allyl, Cyclohex-2-enyl, Trialkylsilyl, oder für eine Gruppe der Formeln:

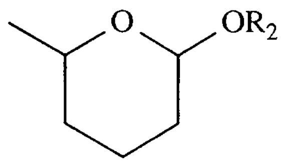 und 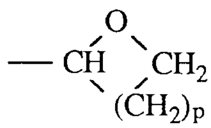

steht, worin $R_2$ für $C_1$-$C_6$-Alkyl und p für eine der Zahlen 4 oder bevorzugt 3 oder 2 stehen. Besonders bevorzugt bedeutet $R_3$ eine $C_4$-$C_{10}$-tert.-Alkylgruppe, insbesondere eine tert.-Butylgruppe oder eine Gruppe der Formel

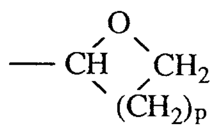 ,

worin p 3 oder 2 bedeutet.

Besonders bevorzugte Bindemittel für oben genannten chemisch verstärkten wässerig alkalisch entwickelbaren Positivphotoresists sind Terpolymere von Methylmethacrylat, Methacrylsäure und säurespaltbaren Methacrylsäureestern der Formel $H_2C=C(CH_3)$-$COOR_3$, worin $R_3$ eine der oben genannten Bedeutungen hat und insbesondere eine tert.-Butyl- oder ein Tetrahydropyranylgruppe darstellt. Bevorzugt enthalten diese Polymere Methylmethacrylatbaugruppen zu etwa 40 bis 50 Molprozent, damit das Polymer u. a. gute Filmbildungseigenschaften zeigt, und etwa 10 bis 25 Molprozent Methacrylsäure, während der Rest des Polymers von den säurespaltbaren Methacrylsäureestern gebildet wird.

Am meisten bevorzugt ist schliesslich ein chemisch verstärkter wässerig alkalisch entwickelbarer Photoresist, der einen strahlungsempfindlichen Säurespender, als Komponente B eines der oben beschriebenen Terpolymere von Methylmethacrylat, Methacrylsäure und säurespaltbare Methacrylsäureestern der Formel $H_2C=C(CH_3)$-$COOR_3$ und als latent aromatische Verbindung Bicyclo[3.2.2]nona-6,8-dien-3-on enthält, wobei das Gewichtsverhältnis von Komponente B zu latent aromatischer Verbindung zwischen 4 : 1 und 1,5 : 1 liegt.

Alle erfindungsgemässen Photoresists können ausserdem geeignete übliche Zusatzstoffe enthalten, wie z.B. Stabilisatoren, Pigmente, Farbstoffe, Füllstoffe, Haftvermittler, Verlaufmittel, Netzmittel und Weichmacher.

Bevorzugt sind die Photoresistzusammensetzungen zur Applikation in einem geeigneten Lösungsmittel gelöst. Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder enfernt werden können. Geeignete Lösungsmittel sind z.B. Ketone, Ether und Ester, wie Methylethylketon, 2-Heptanon, Cyclopentanon, Cyclohexanon, $\gamma$-Butyrolacton, Ethylpyruvat, Diethylenglykoldimethylether, 2-Methoxyethanol, 2-Ethoxyethanol, 2-Ethoxyethylacetat, 1-Methoxy-2-propylacetat, 1,2-Dimethoxyethan, Essigsäureethylester und 3-Methoxymethylpropionat oder Gemische dieser Lösungsmittel.

Die in einem Lösungsmittel gelösten Photoresistzusammensetzungen eignen sich hervorragend als Beschichtungsmittel für Substrate aller Art, insbesondere für Metalle, wie Al, Cu, Ni, Fe, Zn, Mg oder Co, und für GaAs, Si oder $SiO_2$, auf denen durch bildmässiges Belichten eine Abbildung aufgebracht werden soll.

Ein weiterer Gegenstand der Erfindung ist ein Verfahren zur Behandlung eines Substrats, das zumindest die folgenden Verfahrensstufen umfasst:

- Beschichtung des Substrats mit einer Photoresistzusammensetzung,
- selektive Bestrahlung dieser Photoresistbeschichtung und
- Behandlung der bestrahlten Beschichtung mit einer Entwicklerlösung, wobei die Resistbeschichtung bildhaft strukturiert wird,

wobei

- die Photoresistbeschichtung für Strahlung mit einer Wellenlänge von ca. 193 nm ausreichend transparent ist und nichtaromatische chemische Gruppen enthält, die sich unter Verfahrensbedingungen, bei denen eine bildhafte

Struktur aus dem Resistmaterial nicht zerstört wird, in Gruppen mit aromatischen Strukturelementen überführen lassen,

- zur selektiven Bestrahlung der Photoresistbeschichtung eine Strahlung von ca. 193 nm Wellenlänge eingegesetzt wird und
- die bildhaft strukturierte Resistbeschichtung einer Behandlung unterzogen wird, bei der ihre bildhafte Struktur nicht zerstört wird und bei der die genannten nichtaromatischen Gruppen in Gruppen mit aromatischen Strukturelementen überführt werden.

Bevorzugt kommt bei diesem Verfahren ein chemisch verstärkter Resist zur Anwendung, insbesondere ein chemisch verstärkter, alkalisch entwickelbarer Positivphotoresist.

Zur Durchführung des erfindungsgemässen Verfahrens wird die Photoresistzusammensetzung wird mittels bekannter Beschichtungsverfahren gleichfömig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung.

Die Auftragsmenge (Schichtdicke) und die Art des Substrats (Schichtträger) sind vom gewünschten Applikationsgebiet abhängig. Der Schichtdickenbereich umfasst im allgemeinen Werte von ca. 0,1 µm bis mehr als 10 µm.

Nach dem Beschichten wird das Lösungsmittel in der Regel durch Trocknen entfernt, wobei eine Photoresistbeschichtung auf dem Träger erhalten wird.

Erfindungsgemässe strahlungsempfindliche Zusammensetzungen eignen sich als Photoresists für die Elektronik (Galvanoresist, Aetzresist, Lötstoppresist), für die Herstellung von Druckplatten, wie Offsetdruckplatten oder Siebdruckformen, für den Einsatz beim Formteilätzen, aber besonders für den Einsatz als Mikroresist bei der Herstellung integrierter Schaltkreise.

Den unterschiedlichen Anwendungsbereichen entsprechend verschieden sind die möglichen Schichtträger und die Verarbeitungsbedingungen der beschichteten Substrate. Als Substrat für Offsetdruckformen dient z. B. speziell behandeltes Aluminium, für die Herstellung gedruckter Schaltungen kupferkaschierte Laminate und für die Herstellung von integrierten Schaltkreisen Siliziumwafer. Die Schichtdicken für Offsetdruckformen betragen in der Regel ca. 0,5 µm bis 10 µm, für gedruckte und integrierte Schaltungen 0,4 bis ca. 2 µm, für integrierte Schaltungen insbesondere 0,4 bis 1 µm.

Zur Herstellung von Reliefstrukturen wird das mit dem erfindungsgemässen Photoresist beschichtete Substrat selektiv, d. h. bildmässig belichtet. Die Belichtung erfolgt dabei mit einem Argonfluorid-Excimerlaser mit 193nm-Strahlung, entweder durch eine Maske, bevorzugt eine Chrom-Quarz-Maske, oder indem der Laserstrahl computergesteuert über die Oberfläche des beschichteten Substrates bewegt und so ein Bild erzeugt wird. Hier ist die hohe Empfindlichkeit der erfindungsgemässen Photoresistmaterialien sehr vorteilhaft, die hohe Schreibgeschwindigkeiten bei relativ niedrigen Intensitäten erlaubt. Die hohe Empfindlichkeit der Resists ist auch für die Belichtung mittels Steppern von Vorteil, wo sehr kurze Belichtungszeiten erwünscht sind.

Bei Verwendung chemisch verstärkter Resists umfasst das beschriebene Verfahren bevorzugt zwischen selektiver Bestrahlung und Behandlung mit dem Entwickler eine Erwärmung der Beschichtung als eine weitere Verfahrensmassnahme. Mit Hilfe dieser Wärmebehandlung, dem sogenannten "post exposure bake", erreicht man in besonders schneller Zeit eine praktisch vollständige Reaktion des Resistmaterials. Die Dauer und die Temperatur dieses post exposure bake können in weiten Bereichen variieren und hängen im wesentlichen von der Zusammensetzung des Resists, insbesondere von der Art seiner säureempfindlichen Komponenten und der Art des verwendeten strahlungsempfindlichen Säurespenders sowie von den Konzentrationen dieser beiden Komponenten, ab.

Üblicherweise wird der belichtete Resist wenige Sekunden bis einige Minuten Temperaturen von etwa 50-150 °C ausgesetzt.

Nach der bildmässigen Belichtung und gegebenenfalls durchgeführten Wärmebehandlung des Materials werden die besser löslichen Stellen des Photolackes durch Herauslösen in einem Entwickler entfernt. Die Wahl des jeweiligen Entwicklers richtet sich nach der Art des Photolackes, insbesondere nach der Natur des verwendeten Bindemittels oder der entstehenden Photoprodukte.

Besonders für die Positivresists gemäss der Erfindung eignen sich wässrige Lösungen von Basen als Entwickler, denen gegebenenfalls auch organische Lösungsmittel oder deren Mischungen zugesetzt werden können.

Besonders bevorzugt als Entwickler werden wässerig alkalische Lösungen, wie sie auch für die Entwicklung von Novolak-Naphthochinondiazid-Resistbeschichtungen eingesetzt werden. Dazu zählen z. B. wässrige Lösungen von Alkalimetallsilikaten, - phosphaten, -hydroxiden und -carbonaten, insbesondere aber von Tetraalkylammoniumhydroxidlösungen, wie z. B. von Tetramethylammoniumhydioxidlösung, die frei von Metallionen sind. Diesen Lösungen können gegebenenfalls noch kleinere Mengen an Netzmitteln und/oder organischen Lösungsmitteln zugesetzt sein. Typische organische Lösungsmittel, die den Entwicklerflüssigkeiten zugesetzt werden können, sind beispielsweise Cyclohexanon, 2-Ethoxyethanol, Toluol, Aceton, Isopropanol, Ethanol, sowie Mischungen zweier oder mehrerer dieser Lösungsmittel.

Nach der Entwicklung erfolgt die Umwandlung der latent aromatischen Gruppen im Resist zu in Gruppen mit aromatischen Strukturelementen. Dies geschieht im allgemeinen durch Erhitzen der bildhaft strukturierten Resistbeschichtung auf Temperaturen zwischen 90 und 200 °C, z. B. mit Hilfe einer Hotplate. Die Dauer der Erhitzung liegt üblicherweise zwischen einer halben Minute und einigen Minuten.

Im allgemeinen wird nach dem Entwicklungsschritt das die bildmässig strukturierte Beschichtung aufweisende Substrat zumindest auf der beschichteten Seite mindestens einem weiteren Behandlungsschritt unterzogen, der an den freien Stellen des Substrats zu einer Veränderung des Substrats führt. Eine häufig angewandte Strukturierungsmassnahme ist die Plasmaätzung, beispielsweise mit HBr-, $CF_4$-, Chlor- oder Sauerstoffplasma. Hierbei zeichnen sich die erfindungsgemäss hergestellten Resistbeschichtungen durch eine besonders gute Ätzstabilität aus, d. h. dadurch, dass das Plasma das Resistmaterial nur sehr langsam angreift und abträgt. Weiterhin zeichnen sich die erfindungsgemässen Resistzusammensetzungen unter anderem noch durch gute anwendungstechnische Eigenschaften sowie hohe thermische Stabilität und ein sehr gutes Auflösungsvermögen im Submikronbereich aus.

Gegebenenfalls folgt danach als eine zusätzliche Verfahrensmassnahme die Entfernung der strukturierten Resistbeschichtung von dem Substrat, z. B mit heissem Sauerstoff.

Einen weiteren Gegenstand der Erfindung stellt daher ein Verfahren zur Herstellung eines elektronischen Bauelementes dar, das ein Verfahren zur Behandlung eines Substrats, wie es oben beschrieben wurde, umfasst.

Beispiel 1: Herstellung eines Terpolymers aus Methacrylsäure, Methylmethacrylat und 2-Tetrahydiopyranyl-methacrylat.

In einem 100 ml Dreihalsrundkolben werden 8,51 g (50 mMol) 2-Tetrahydropyranylmethacrylat sowie 2,5 g (25 mMol) Methylmethacrylat und 2,15 g (25 mMol) Methacrylsäure und 0,3 g Azobisisobutyronitril (AIBN) in 100 ml Tetrahydrofuran gelöst. Man rührt das Gemisch 24 Stunden bei 70 °C unter Stickstoff-Inertatmosphäre. Das gewünschte Terpolymer durch Fällung aus 500 ml Methanol isoliert. Ausbeute: 11,8 g (90% der Theorie); Mw = 24300, Mn = 8400, Mw/Mn = 2,8).

Es werden Beschichtungen des reinen Terpolymers sowie der in Tabelle 1 angegebenen Gemische des Terpolymers mit Bicyclo[3.2.2]nona-6,8-dien-3-on als latentem Aromaten und 1%, bezogen auf den Gesamtfeststoffgehalt, Triphenylsulfoniumtriflat hergestellt, indem man entsprechende Lösungen in Cyclopentanon auf ein Substrat aufbringt, trocknet, mit einer Dosis von 20 $mJ/cm^2$ bestrahlt und danach zur Aromatisierung 12 Stunden bei Raumtemperatur reagieren lässt. Mit Hilfe eines Plasmaätzers vom Typ Alcatel CF 2P® wird die Ätzrate der Beschichtungen im Sauerstoffplasma bestimmt und mit der eines üblichen Cresolnovolaks (Novolak Resin P-28 von OCG) sowie eines handelsüblichen Positivphotoresists auf Novolakbasis (Microposit® 1350 von SHIPLEY) verglichen, wobei folgende Verfahrensbedingungen angewandt wurden: Flow = 10 $s \cdot cm^3$, RF Power = 30 W, $O_2$ Pressure = 2 Pa, Bias = 420 V.

Es wird eine Resistformulierung bereitgestellt aus 0,74 g des oben angeführten Terpolymers, 0,25 g Bicyclo[3.2.2]nona-6,8-dien-3-on (hergestellt gemäss A. E. Hill et al.: "ONE STAGE SYNTHESIS OF BICYCLO[3.2.2]NONA-6,8-DIEN-3-ONES", Journal of the American Chemical Society, Vol. 96 (1974), S. 4601; $\varepsilon_{193nm}$ = 3500) und 0,01 g Triphenylsulfoniumtriflat, gelöst in 4 ml Cyclopentanon. Diese Lösung wird bei einer Tourenzahl von 3000 U/min auf einen 3-Zoll Siliziumwafer aufgeschleudert, der danach auf einer Wärmeplatte bei 60 °C 1 min erhitzt wird, wobei ein Resistfilm von 0,8 µm auf dem Substrat verbleibt, dessen Extinktion bei 193 nm ca. 0,75/µm beträgt. Der Film wird durch eine Chrom-Quarz-Maske mit kleinsten Struktureinheiten von 0,5 µm mit Strahlung einer Wellenlänge von 193 nm bildmässig belichtet, erzeugt von einem Lamda Physics LPF 205® Excimer Laser (ArF-Modus). Nach der Belichtung wird das Substrat auf der Wärmeplatte 1 min auf 50 °C erhitzt und der Film mit einer 0,1 N Lösung von Tetramethylammoniumhydroxid in Wasser entwickelt, wobei die zuvor bestrahlten Bereiche des Films weggelöst werden. Schliesslich wird die resultierende bildmässig strukturierte Resistbeschichtung während 12 Stunden bei Raumtemperatur belassen und aromatisiert. Die Ätzrate im Sauerstoffplasma beträgt danach ca. 140 nm/min.

Tabelle 1

| Material | Ätzrate [nm/min] | Ätzrate, relativ[1)] |
|---|---|---|
| Cresolnovolack P-28 | 90 | |
| Microposit®1350 Resist | 106 | 1 |
| Terpolymer aus Beispiel 1 | 200 | 1,9 |
| Gemische des Terpolymers mit latentem Aromaten | | |
| 40 Gew.-% latenter Aromat | 105 | 1 |
| 33 Gew.-% latenter Aromat | 103 | 1 |
| 20 Gew.-% latenter Aromat | 135 | 1,25 |
| 16 Gew.-% latenter Aromat | 150 | 1,4 |

[1)]bezogen auf die Ätzrate von Microposit®1350

Beispiel 2:

Es wird eine Zusammensetzung hergestellt durch Auflösen von 0,75 g des Terpolymers aus Beispiel 1, 0,2 g cis-3-Methyl-3,5-cyclohexadien-1,2-diol und 0,05 g Triphenylsulfoniumtriflat, gelöst in 0,5 g Cyclopentanon. Die Lösung wird bei bei 2800 U/min auf einen Quarzwafer aufgeschleudert, der danach während einer Minute bei 90 °C auf der Hotplate getrocknet wird, wobei ein Film von 1 µm Dicke zurückbleibt, der eine Extinktion von 0,7/µm bei 193 nm aufweist. Der Film wird mit einer Strahlendosis von 24 $mJ/cm^2$ belichtet und 2 Tage bei Raumtemperatur stehen lassen Danach zeigt er aufgrund der Aromatisierung eine Extinktion von 1,6/µm bei 193 nm.

**Patentansprüche**

**1.** Photoresistzusanmmensetzung, welche in lösungsmittelfreiem Zustand für Strahlung einer Wellenlänge von ca. 193 nm ausreichend transparent ist und welche nichtaromatische chemische Gruppen enthält, die sich unter Verfahrensbedingungen, bei denen eine bildhafte Struktur aus dem Resistmaterial nicht zerstört wird, in Gruppen mit aromatischen Strukturelementen überführen lassen (latent aromatische Gruppen).

**2.** Photoresistzusammensetzung gemäss Anspruch 1, die in lösungsmittelfreiem Zustand eine Extinktion von höchstens 0,5/µm für Strahlung von 193 nm Wellenlänge zeigt.

**3.** Photoresistzusammensetzung gemäss Anspruch 1 oder 2, die die latent aromatischen Gruppen vorzugsweise in einer Menge enthält, dass die Ätzrate des Resists im Sauerstoffplasma 150 bis 100 (± 10) nm/min beträgt, bestimmt mit einem Plasmaätzer des Typs Alcatel CF 2P® (Flow: 10 s • $cm^3$; RF Power: 30 W; $O_2$ Pressure: 2,0 Pa und Bias: 420 V).

**4.** Photoresistzusammensetzung nach Anspruch 1 bis 3, die die latent aromatische Gruppen als Bicyclo[3.2.2]nona-6,8-dien-3-on enthält.

**5.** Photoresistzusammensetzung nach Anspruch 1 bis 4, die chemische Gruppen enthält, die unter dem Einfluss von Strahlung eine starke Säure bilden, sowie Gruppen, die unter katalytischer Wirkung dieser Säure die Löslichkeit des Resists in wässerig alkalischen Entwicklern erhöhen.

**6.** Photoresistzusammensetzung gemäss Anspruch 5, die die folgenden Komponenten enthält:

A) eine Verbindung, die unter dem Einfluss von Strahlung eine starke Säure bildet,
B) ein filmbildendes für Strahlung von ca. 193 nm Wellenlänge ausreichend transparentes Bindemittel, das säurekatalytisch spaltbare Gruppen aufweist, und
C) eine Verbindung mit latent aromatischen Gruppen

oder anstatt der Komponenten B) und C)

D) ein filmbildendes für Strahlung von ca. 193 nm Wellenlänge ausreichend transparentes Bindemittel, das säurekatalytisch spaltbare Gruppen und latent aromatischen Gruppen aufweist.

**7.** Photoresistzusammensetzung gemäss Anspruch 6, die als Komponente B ein Terpolymer aus Methylmethacrylat, Methacrylsäure und Methacrylsäureester der Formel $H_2C{=}C(CH_3){-}COOR_3$ enthält, worin $R_3$ für $C_4$-$C_{10}$-tert.-Alkyl, unsubstituiertes oder durch eine oder mehrere $C_1$-$C_6$-Alkylgruppen, $C_1$-$C_6$-Alkoxygruppen oder Halogenatome substituiertes Allyl, Cyclohex-2-enyl, Trialkylsilyl, oder für eine Gruppe der Formeln:

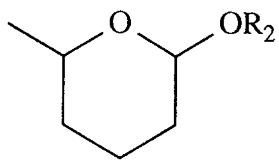

und

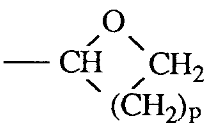

steht, worin $R_2$ für $C_1$-$C_6$-Alkyl und p für eine der Zahlen 4, 3 oder 2 stehen.

**8.** Photoresistzusammensetzung gemäss Anspruch 6 oder 7, die als Komponente A ein Sulfoniumsalz der Formel (II) enthält

$$(Ar_1)_q(Z_1)_r(Z_2)_sS^{\oplus}X_1^{\ominus} \qquad \text{(II)},$$

worin

| | |
|---|---|
| $Ar_1$ | unsubstituiertes oder durch Halogen, $C_1$-$C_4$-Alkyl, $C_1$-$C_4$-Alkoxy, -OH und/oder nitro-substituiertes Phenyl, Naphthyl oder Phenyl-$COCH_2$- ist, |
| $Z_1$ | $C_1$-$C_6$-Alkyl oder $C_3$-$C_7$-Cycloalkyl und |
| $Z_2$ | Tetrahydrothienyl, Tetrahydrofuryl oder Hexahydropyryl sind, |
| q | für 0, 1, 2 oder 3, |
| r | für 0, 1 oder 2 und |
| s | für 0 oder 1 stehen, wobei die Summe q+r+s 3 beträgt, und |
| $X_1^{\ominus}$ | ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist. |

**9.** Photoresistzusammensetzung gemäss Anspruch 7, die als latent aromatische Verbindung Bicyclo[3.2.2]nona-6,8-dien-3-on enthält, wobei das Gewichtsverhältnis von Bindemittel zu latent aromatischer Verbindung zwischen 4 : 1 und 1,5 : 1 liegt.

**10.** Verfahren zur Behandlung eines Substrats, das zumindest die folgenden Verfahrensstufen umfasst:

- Beschichtung des Substrats mit einer Photoresistzusammensetzung,
- selektive Bestrahlung dieser Photoresistbeschichtung und
- Behandlung der bestrahlten Beschichtung mit einer Entwicklerlösung, wobei die Resistbeschichtung bildhaft strukturiert wird,

wobei

- die Photoresistbeschichtung für Strahlung mit einer Wellenlänge von ca. 193 nm ausreichend transparent ist und nichtaromatische chemische Gruppen enthält, die sich unter Verfahrensbedingungen, bei denen eine bildhafte Struktur aus dem Resistmaterial nicht zerstört wird, in Gruppen mit aromatischen Strukturelementen überführen lassen,
- zur selektiven Bestrahlung der Photoresistbeschichtung eine Strahlung von ca. 193 nm Wellenlänge eingegesetzt wird und
- die bildhaft strukturierte Resistbeschichtung einer Behandlung unterzogen wird, bei der ihre bildhafte Struktur nicht zerstört wird und bei der die genannten nichtaromatischen Gruppen in Gruppen mit aromatischen Strukturelementen überführt werden.

**11.** Verfahren nach Anspruch 10, das zwischen der selektiven Bestrahlung und der Behandlung mit dem Entwickler die Erwärmung der Beschichtung umfasst.

**12.** Verfahren nach Anspruch 10 oder 11, wobei ein chemisch verstärkter Photoresist, insbesondere ein chemisch verstärkter, wässerig alkalisch entwickelbarer Positivphotoresist zur Anwendung kommt.

**13.** Verfahren zur Herstellung eines elektronischen Bauelementes, umfassend ein Verfahren nach Anspruch 10 bis 12.

Europäisches Patentamt

# EUROPÄISCHER RECHERCHENBERICHT

Nummer der Anmeldung
EP 95 81 0170

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,X | DATABASE WPI<br>Week 9315<br>Derwent Publications Ltd., London, GB;<br>AN 93-122216<br>& JP-A-05 061 168 (SONY CORP.) , 12.März 1993<br>* Zusammenfassung *<br>--- | 1-3,10, 11 | G03F7/039<br>G03F7/40 |
| A | DE-A-44 00 975 (TOSHIBA KAWASAKI KK)<br>21.Juli 1994<br>----- | | |

| RECHERCHIERTE SACHGEBIETE (Int.Cl.6) |
|---|
| G03F |

Der vorliegende Recherchenbericht wurde für alle Patentansprüche erstellt

| Recherchenort | Abschlußdatum der Recherche | Prüfer |
|---|---|---|
| DEN HAAG | 17.August 1995 | Haenisch, U |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument

EPO FORM 1503 03.82 (P04C03)